# EUROPÄISCHE PATENTANMELDUNG

(11) **EP 0 562 233 A1**
(43) Veröffentlichungstag der Anmeldung: **29.09.1993**
(21) Anmeldenummer: 93101021.9
(22) Anmeldetag: 23.01.1993
(51) Int. Cl.: H01S 3/06, H01S 3/131

(54) **Faseroptischer Verstärker mit Regelung der Pumplicht-Wellenlänge**

(30) Priorität: 19.03.1992 DE 4208858
(71) Anmelder: Alcatel SEL Aktiengesellschaft, D-70435 Stuttgart (DE); ALCATEL N.V., NL-1077 XX Amsterdam (NL)
(72) Erfinder: Heidemann, Rolf, Dr., W-7146 Tamm (DE)
(74) Vertreter: Kugler, Hermann, Dipl.-Phys.

(57) **Zusammenfassung**

Bei faseroptischen Verstärkern, zum Beispiel solchen, die ein Er³⁺-dotiertes Lichtwellenleiterstück (1) enthalten, muß die Wellenlänge des von der Pumplicht-Quelle (2) erzeugten Pumplichts möglichst genau bei derjenigen Wellenlänge liegen, die als Pumplicht-Wellenlänge für das verstärkende Lichtwellenleiterstück (1) gewünscht ist. Abweichungen davon beeinträchtigen die Leistungsfähigkeit des optischen Verstärkers sehr. Erfindungsgemäß enthält der faseroptische Verstärker eine Regelvorrichtung, die die Wellenlänge des von der Pumplicht-Quelle (2) erzeugten Pumplichts auf das bei der gewünschten Wellenlänge liegende Maximum der Absorption regelt. Vorzugsweise geschieht dies, indem ein Teil des Pumplichts in ein Referenz-Lichtwellenleiterstück (10) eingekoppelt wird, das bei derselben Wellenlänge eine maximale Absorption hat wie das verstärkende Lichtwellenleiterstück (1), und indem die Absorption in dem Referenz-Lichtwellenleiterstück (10) als Regelkriterium verwendet wird.

## Beschreibung

Die Erfindung betrifft einen faseroptischen Verstärker nach dem Oberbegriff des Patentanspruchs 1. Ein solcher faseroptischer Verstärker ist vielfach bekannt, beispielsweise aus: "ECOC '89", 15th European Conference on Optical Communication, September 10-14, 1989, Gothenburg, Sweden, Proceedings, VOL. 1, Regular Papers TUA 5-7, Seiten 86-89. Das verstärkende Lichtwellenleiterstück ist dort ein Er³⁺-dotiertes Lichtwellenleiterstück, und das Licht der Pumplicht-Quelle wird über einen Koppler in das verstärkende Lichtwellenleiterstück eingekoppelt. Zwei verschiedene Varianten sind dort erläutert. Bei der ersten (co-propagating configuration) ist der Pumplicht-Koppler bezogen auf die Übertragungsrichtung bis zur Verstärkung des optischen Signals vor dem verstärkenden Faserstück angeordnet. Bei der zweiten Konfiguration (counter-propagating configuration) befindet sich der das Pumplicht in das verstärkende Lichtwellenleiterstück einkoppelnde Koppler, bezogen auf die Übertragungsrichtung des zu verstärkenden optischen Signals, hinter dem Lichtwellenleiterstück. Für die vorliegende Erfindung spielt der Unterschied zwischen den beiden Konfigurationen keine Rolle.

Der hier interessierende Aspekt des faseroptischen Verstärkers ist seine Pumplichtquelle, genauer gesagt die Wellenlänge des von ihr erzeugten Pumplichts. Aus T.R. Chen: "Structural and Compositional Control of the Output Wavelength of Very High Power 0,98 µm GaInAs Lasers for Pumping Fiber Amplifiers", IEEE Photonics Technology Letters, VOL. 3, NO. 8, August 1991, Seiten 694 bis 696 ist bekannt, daß die Leistungsfähigkeit von faseroptischen Verstärkern mit Er³⁺-dotierten verstärkenden Lichtwellenleiterstücken wesentlich von der Wellenlänge des von der Pumplicht-Quelle erzeugten Pumplichts abhängt. Demnach sollte die Wellenlänge des von der Pumplichtquelle erzeugten Lichts bei 980 nm mit einer Toleranz von 2 nm liegen. Es werden verschiedene Maßnahmen beschrieben, um bei der Fertigung eines bestimmten Halbleiter-Lasers dafür zu sorgen, daß seine Wellenlänge in diesem Bereich liegt.

Auch wenn man es bei der Fertigung des Halbleiterlasers erreicht, daß seine Emissionswellenlänge genau oder nahe bei der als Pumplicht für den faseroptischen Verstärker geeigneten Wellenlänge liegt, so kann es beim Einsatz des Halbleiterlasers in einem faseroptischen Verstärker dennoch Schwierigkeiten geben, zum Beispiel, weil die Emissionwellenlänge durch Alterung des Halbleiterlasers oder abhängig von der Umgebungstemperatur sich ändern kann. Die genannte Veröffentlichung geht auf solche Schwierigkeiten nicht ein, sondern beschäftigt sich lediglich damit, wie man bei der Fertigung die gewünschte Wellenlänge möglichst genau erreichen kann.

Es ist die Aufgabe der Erfindung, einen faseroptischen Verstärker anzugeben, der hinsichtlich der Wellenlänge seiner Pumplicht-Quelle verbessert ist.

Die Aufgabe wird wie in Patentanspruch 1 angegeben gelöst. Weiterbildungen ergeben sich aus den Unteransprüchen.

Die Erfindung wird nun anhand der Zeichnungen, die Ausführungsbeispiele zeigen, näher erläutert. Es zeigen:
- Fig. 1: ein erstes Ausführungsbeispiel eines erfindungsgemäßen faseroptischen Verstärkers, bei dem die Absorption des Pumplichts im verstärkenden Lichtwellenleiterstück als Kriterium zur Regelung der Pumplaser-Wellenlänge verwendet ist,
- Fig. 2: ein zweites Ausführungsbeispiel des erfindungsgemäßen faseroptischen Verstärkers, bei dem die Absorption in einem Referenz-Lichtwellenleiterstück als Kriterium zur Regelung der Pumplaser-Wellenlänge verwendet ist, und
- Fig. 3: schematisch den wellenlängenabhängigen Verlauf der Absorption von Licht im Bereich von 980 nm in einem Er³⁺-dotierten Lichtwellenleiterstück zur Erläuterung der Regelung der Wellenlänge auf das Maximum der Absorption.

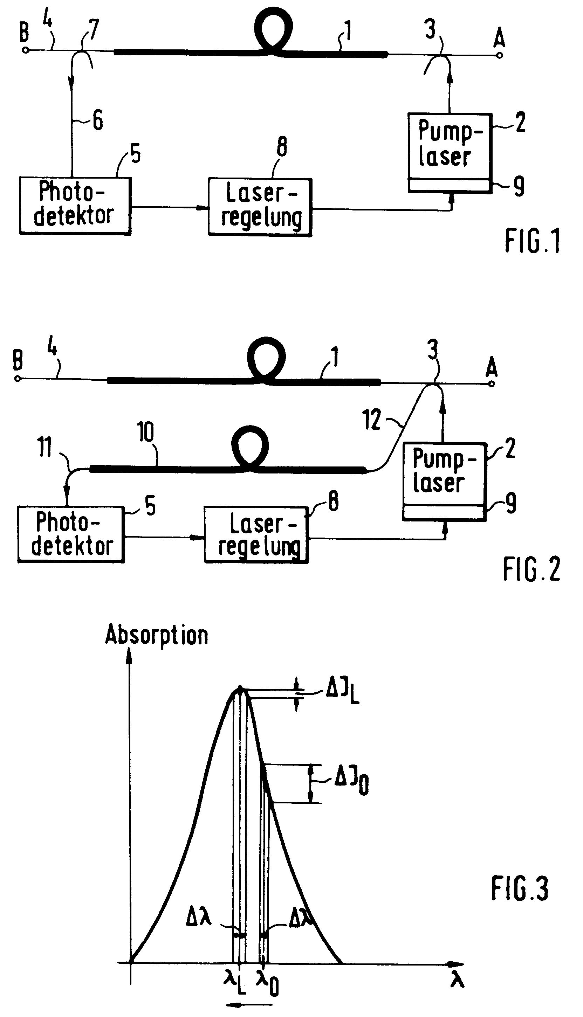

Der faseroptische Verstärker nach Fig. 1 besteht wie bekannte faseroptische Verstärker im wesentlichen aus einem Lichtwellenleiterstück 1, das als verstärkendes Lichtwellenleiterstück eines faseroptischen Verstärkers geeignet ist, beispielsweise einem Stück eines Er³⁺-dotierten Lichtwellenleiters, einem Halbleiterlaser 2, der das Pumplicht für den faseroptischen Verstärker erzeugt, und einem Pumplicht-Koppler 3, der mit einem Ende des Lichtwellenleiterstücks 1 verbunden ist und dazu dient, das vom Halbleiterlaser 2 erzeugte Pumplicht in das Lichtwellenleiterstück 1 einzukoppeln. Der Halbleiterlaser 2 wird im folgenden bisweilen als Pumplaser bezeichnet. Zusammen mit nicht gezeigten Stromversorgungs-Einrichtungen bildet er die Pumplicht-Quelle des faseroptischen Verstärkers. Ein Anschluß A des faseroptischen Kopplers 3 bildet den Ein- oder Ausgang des faseroptischen Verstärkers.

Auf der anderen Seite des Lichtwellenleiterstücks 1 führt ein Lichtwellenleiterstück 4 zu einem Anschluß B des faseroptischen Verstärkers. Der faseroptische Verstärker kann entweder so betrieben werden, daß sein Signallicht-Eingang der Anschluß A und sein Signallicht-Ausgang der Anschluß B ist oder umgekehrt. Soweit bisher beschrieben, handelt es sich um einen bekannten faseroptischen Verstärker.

Erfindungsgemäß enthält er zusätzlich einen Photodetektor 5, dessen optischer Eingang über ein Lichtwellenleiterstück 6 und einen faseroptischen Koppler 7 mit dem Ende des Lichtwellenleiterstücks 1 verbunden ist, das über das Lichtwellenleiterstück 4 mit dem Anschluß B verbunden ist. Das Lichtwellenleiterstück 4 kann Teil des faseroptischen Kopplers 7 sein. Der Photodetektor 5 empfängt einen Teil des im Lichtwellenleiterstück 1 nicht absorbierten Pumplichts und setzt es in ein dessen Intensität entsprechendes elektrisches Signal um. Sein elektrisches Ausgangssignal gelangt zu einer Laser-Regelschaltung 8, die in einem gewünschten Wellenlängenbereich den Pumplaser 2 so regelt, daß das von ihm erzeugte Pumplicht im Lichtwellenleiterstück 1 maximal absorbiert wird, d.h., daß die Intensität des aus dem Lichtwellenleiterstücks 1 austretenden Pumplichts minimal wird. Der faseroptische Koppler 7 ist wellenlängenselektiv, derart, daß er nur Pumplicht und kein Signallicht zum optischen Eingang des Photodetektors 5 koppelt.

In der Fig. 1 ebenso wie in der noch zu erläuternden Fig. 2 ist das verstärkende Lichtwellenleiterstück dicker dargestellt als die normalen Lichtwellenleiterstücke, die als Teile von Kopplern und als sonstige Anschlußstücke verwendet sind, um es von diesen abzuheben. Selbstverständlich ist es in Wirklichkeit nicht dicker, sondern nur in seinem Kern anders dotiert.

Im folgenden wird für jegliche optische Strahlung, also auch für die mit Wellenlängen außerhalb des sichtbaren Bereichs, zur Vereinfachung der Ausdruck Licht verwendet. Bevorzugterweise hat das Pumplicht eine Wellenlänge im Bereich von 980 nm und das Signallicht eine Wellenlänge von im Bereich von 1550 nm.

Zur Regelung der Wellenlänge des vom Pumplaser 2 erzeugten Pumplichts wird von der Tatsache Gebrauch gemacht, daß die Wellenlänge von der Temperatur des Halbleiterlasers abhängig ist. Die Temperatur wiederum ist wie bei Halbleiterlasern üblich, thermoelektrisch steuerbar, indem bei dem Laser eine thermoelektrische Kühleinrichtung 9, ein sogenannter Peltier-Kühler, vorhanden ist. Ein elektrischer Kühler-Strom bestimmt dabei die aktuelle Temperatur des Pumplasers 2. Dieser Kühler-Strom wird nun erfindungsgemäß durch die Laser-Regelschaltung 8 so gesteuert, daß die Pumplicht-Wellenlänge in der beschriebenen Weise auf die gewünschte Wellenlänge eingeregelt wird.

Steuerbare thermoelektrische Kühler für Halbleiterlaser oder Halbleiter-Bauelemente sind an sich bekannt, z.B. aus der US-A-4,307,469 oder der DE-C 32 14 614, und bedürfen daher keiner näheren Erläuterung.

Statt über den Kühler-Strom des Laser-Kühlers 9 kann man die Pumplicht-Wellenlänge des Lasers 2 auch durch Regeln seines mittleren Betriebsstroms regeln. Auch eine Kombination einer Regelung über die Temperatur und eine Regelung über den mittleren Betriebsstrom ist möglich. Wie die Laser-Regelung arbeitet, wird an späterer Stelle erläutert.

Zuvor wird anhand von Fig. 2 ein zweites Ausführungsbeispiel des erfindungsgemäßen faseroptischen Verstärkers erläutert. Wie bei Fig. 1 handelt es sich auch hier um einen faseroptischen Verstärker, der erfindungsgemäß um einen Photodetektor 5 und eine Laser-Regelschaltung 8 ergänzt ist, die aufgrund des elektrischen Ausgangssignals des Photodetektors 5 die Pumplicht-Wellenlänge des Pumplasers 2 regelt, vorzugsweise über den Kühler-Strom des thermoelektrischen Kühlers 9 des Pumplasers 2. Im Gegensatz zum Ausführungsbeispiel nach Fig. 1 empfängt der Photodetektor 5 hier nicht das aus dem verstärkenden Lichtwellenleiterstück 1 austretende Pumplicht, sondern Pumplicht, das aus einem Referenz-Lichtwellenleiterstück 10 austritt, in dessen anderes Ende vom Pumplaser 2 erzeugtes Pumplicht eingekoppelt wird. Ein Teil des vom Pumplaser 2 erzeugten Pumplichts wird in das eine Ende des Referenz-Lichtwellenleiterstücks 10 eingekoppelt, und das dort nicht absorbierte Licht gelangt vom anderen Ende des Referenz-Lichtwellenleiterstücks 10 zum optischen Eingang des Photodetektors, entweder über ein Lichtwellenleiterstück 11 oder dadurch, daß das Referenz-Lichtwellenleiterstück bis zum optischen Eingang des Photodetektors 5 geführt ist.

Als Mittel, um einen Teil des vom Pumplaser 2 erzeugten Pumplichts in das eine Ende des Referenz-Lichtwellenleiterstücks einzukoppeln, wird, wie in Fig. 2 gezeigt, vorzugsweise der ohnehin vorhandene faseroptische Koppler 3 verwendet, indem dessen freier Kopplerausgang über ein Lichtwellenleiter-Anschlußstück 12 mit dem genannten Ende des Referenz-Lichtwellenleiterstücks 10 verbunden ist. Der faseroptische Koppler 3 ist ein wellenlängenselektiver Koppler, der an seinem freien Koppelausgang nur Pumplicht und kein Signallicht ausgibt. Das Lichtwellenleiter-Anschlußstück 12 kann auch entfallen, wenn das Referenz-Lichtwellenleiterstück 10 direkt bis zum freien Anschluß des faseroptischen Kopplers 3 geführt ist.

Die wesentliche Eigenschaft des Referenz-Lichtwellenleiterstücks 10 ist, daß es sein Maximum der Lichtabsorption im Wellenlängenbereich des Pumplichts bei derselben Wellenlänge hat wie das verstärkende Lichtwellenleiterstück 1. Selbstverständlich ist dies der Fall, wenn es sich um ein Lichtwellenleiterstück derselben Art wie das verstärkende Lichtwellenleiterstück 1 handelt. Bekanntlich kann es aber auch dann der Fall sein, wenn sich das Referenz-Lichtwellenleiterstück 10 durch eine andere Kerndotierung, abgesehen vom Dotiermittel Er³⁺, vom verstärkenden Lichtwellenleiterstück 1 unterscheidet. Beispielsweise ist es möglich, als verstärkendes Lichtwellenleiterstück 1 ein solches zu verwenden, dessen Kern nicht nur mit Germanium, sondern auch mit Aluminium dotiert ist, wenn eine solche Zusammensetzung für die Verwendung als verstärkendes Lichtwellenleiterstück in einem faseroptischen Verstärker Vorteile hat. Trotzdem ist es dann günstig, als Referenz-Lichtwellenleiterstück 10 eines zu verwenden, dessen Kern nicht mit Aluminium dotiert ist. Auch ein solches hat nämlich sein Absorptionsmaximum bei derselben Wellenlänge (980 nm), jedoch deutlich ausgeprägter, so daß es als Referenz-Lichtwellenleiterstück zum Einregeln der Pumplicht-Wellenlänge des Pumplasers 2 auf die Wellenlänge der maximalen Absorption des Pumplichts im Lichtwellenleiterstück 1 geeigneter ist. Wesentlich für die Auswahl des Referenz-Lichtwellenleiterstücks 10 ist also lediglich, daß es aufgrund seiner wellenlängenabhängigen Absorption als guter Referenz-Lichtwellenleiter im Verhältnis zum verstärkenden Lichtwellenleiter 1 geeignet ist. In der Zeichnung ist es ebenso wie das verstärkende Lichtwellenleiterstück 1 dicker als die normalen Lichtwellenleiterstücke dargestellt.

Beim Ausführungsbeispiel nach Fig. 2 ist das Kriterium für die Regelung der Wellenlänge des Pumplasers das in einem Referenz-Lichtwellenleiterstück nicht absorbierte Pumplicht, wogegen beim Ausführungsbeispiel nach Fig. 1 das Kriterium für die Laser-Regelung das im verstärkenden Lichtwellenleiterstück nicht absorbierte Pumplicht ist. Der Vorteil der Lösung nach Fig. 2 gegenüber der nach Fig. 1 liegt darin, daß der bei Fig. 1 erforderliche faseroptische Koppler zum Auskoppeln des nicht absorbierten Pumplichts in Richtung zum Photodetektor 5 entfällt und daß die Regelung genauer durchgeführt werden kann, wenn ein speziell als Referenz-Lichtwellenleiterstück für die Zwecke der Regelung der Pumplicht-Wellenlänge ausgewähltes Lichtwellenleiterstück verwendet wird.

Anstatt wie gezeigt den freien Anschluß des ohnehin erforderlichen faseroptischen Kopplers 3 zu verwenden, kann jedes andere Mittel verwendet werden, das dazu geeignet ist, einen Teil des vom Pumplaser 2 erzeugten Lichts in das Referenz-Lichtwellenleiterstück 10 einzukoppeln. Beispielsweise kann auch das am rückwärtigen Ende des Pumplasers 2 austretende Licht in das Referenz-Lichtwellenleiterstück 10 eingekoppelt werden, entweder direkt oder über ein Lichtwellenleiter-Anschlußstück.

Wie die Laser-Regelschaltung 8 vorzugsweise arbeitet, wird nun anhand von Fig. 3 erläutert. Schematisch zeigt sie die starke Wellenlängenabhängigkeit der Absorption, wie sie für ein Er³⁺-dotiertes Lichtwellenleiterstück im Wellenlängenbereich von 980 nm typisch ist. Aus den eingangs geschilderten Gründen sollte die Pumplicht-Wellenlänge idealerweise dort liegen, wo die Absorptionskurve ihr Maximum hat, also bei λ_{L}. In Fig. 2 ist der Fall betrachtet, daß sie davon abweicht und bei λ_{O} liegt, wo die Absorption sehr weit von ihrem Maximum entfernt ist, so daß ein Regelbedarf besteht. Die Regelung bezieht sich nur auf einen gewünschten Wellenlängenbereich, z.B. den um 980 nm, und das dort liegende Absorptionsmaximum. Mit "Maximum" ist also ein lokales Maximum gemeint und nicht das absolut mögliche Maximum aus mehreren lokalen Maxima.

Die Laser-Regelschaltung 8 enthält einen Modulator, der mittels ihres Ausgangs-Steuersignals, das über die Temperatur des Lasers 2 dessen Wellenlänge steuert, die Wellenlänge des Pumplichts mit einer Schwankung von Δλ sehr langsam moduliert, zum Beispiel mit einer Modulationsfrequenz von nur 1 Hz. Eine solche Modulation der Wellenlänge um λ_{O} bewirkt, daß das elektrische Ausgangssignal des Photodetektors eine Signalkomponente mit dieser Modulationsfrequenz enthält. Ihre Stärke entspricht der sich aus der Modulation der Wellenlänge mit der Schwankung Δλ ergebenden Schwankung ΔI_{O} der Intensität des im Photodetektor 5 empfangenen Lichts. Sie ist also umso stärker, je mehr sich die aktuelle Wellenlänge λ_{O}, um die herum die Modulation stattfindet, in einem Bereich starker Steilheit der Absorptionskurve befindet. Aus der genannten Signalkomponente kann also ein Steuersignal zum Verschieben von λ_{O} abgeleitet werden. Geschieht dies durch phasenempfindliche Gleichrichtung der Signalkomponente bezüglich der Phase der Modulation, so ergibt sich auch, welches Vorzeichen das von der Laser-Regelschaltung 8 abzugebende Steuersignal haben muß, das heißt, in welche Richtung λ_{O} verschoben werden muß.

Liegt die aktuelle Wellenlänge λ_{O} in einem Bereich wie es im Beispiel der Fig. 2 gezeigt ist so nimmt die Absorption ab, das heißt, die Intensität des empfangenen Lichtes zu, wenn bei der Modulation die Wellenlänge gerade erhöht wird. Wird also diese Phasenbeziehung festgestellt, so muß λ_{O} verkleinert werden, damit es sich an die optimale Wellenlänge λ_{L} annähert. Läge λ_{O} unterhalb von λ_{L}, so wären diese Phasenbeziehungen umgekehrt, so daß dann λ_{O} erhöht werden müßte.

Eine solche Regelung von λ_{O} in Richtung von λ_{L} aufgrund der Komponente im Ausgangssignal des Photodetektors mit der Modulationsfrequenz wird solange durchgeführt, bis diese Komponente verschwunden ist. Das ist dann der Fall, wenn λ_{O} so nahe bei λ_{L} liegt, daß die Emissionswellenlänge durch die Modulation die optimale Wellenlänge λ_{O} über- und unterschreitet. Statt der Signalkomponente mit der Modulationsfrequenz erscheint dann im Ausgangssignal des Photodetektors eine Signalkomponente mit der doppelten Modulationsfrequenz, weil dann innerhalb einer Modulationsperiode der Wellenlänge die Absorption ihr Maximum zweimal durchläuft. Wie im Beispiel der Fig. 2 gezeigt, ist dann die Schwankung ΔI_{L} auf das Minimum reduziert.

Als bevorzugte Ausführungsbeispiele für die Lichtwellenleiterstücke wurden im Vorstehenden solche betrachtet, die mit Er³⁺ als laseraktiver Substanz dotiert sind. Stattdessen können auch Lichtwellenleiterstücke verwendet werden, die mit einer anderen laseraktiven Substanz, z.B. Nd oder Yb, dotiert sind.

## Patentansprüche

1. Faseroptischer Verstärker für optische Nachrichtenübertragungssyteme, der ein sein optisches Eingangssignal verstärkendes Lichtwellenleiterstück (1), eine Pumplicht-Quelle mit einem Halbleiterlaser (2) zum Erzeugen von Pumplicht für das verstärkende Lichtwellenleiterstück und Mittel (3) zum Einkoppeln des erzeugten Pumplichts in das verstärkende Lichtwellenleiterstück (1) enthält,
**dadurch gekennzeichnet,**
daß er eine Regelvorrichtung (12, 10, 11, 5, 8, 9) enthält, die in einem gewünschten Wellenlängenbereich die Wellenlänge des vom Halbleiterlaser (2) erzeugten Pumplichts so regelt, daß das Pumplicht im verstärkenden Lichtwellenleiterstück (1) maximal absorbiert wird.

2. Faseroptischer Verstärker nach Anspruch 1, dadurch gekennzeichnet, daß ein Referenz-Lichtwellenleiterstück (1, 10) vorhanden ist, und Mittel, um einen Teil des Pumplichts in das Referenz-Lichtwellenleiterstück einzukoppeln, und daß die Regelvorrichtung die Pumplicht-Wellenlänge in Abhängigkeit von der Absorption des in das Referenz-Lichtwellenleiterstück (1, 10) eingekoppelten Pumplicht-Anteils regelt.

3. Faseroptischer Verstärker nach Anspruch 2, dadurch gekennzeichnet, daß als Referenz-Lichtwellenleiterstück (1) das verstärkende Lichtwellenleiterstück (1) selbst verwendet ist (Fig. 1).

4. Faseroptischer Verstärker nach Anspruch 2, dadurch gekennzeichnet, daß als Referenz-Lichtwellenleiterstück (10) ein Lichtwellenleiterstück verwendet ist, das bei derselben Wellenlänge ein Maximum der Absorption hat wie das verstärkende Lichtwellenleiterstück (1) (Fig. 2).

5. Faseroptischer Verstärker nach Anspruch 3 oder 4, dadurch gekennzeichnet,
- daß die Regelvorrichtung einen Photodetektor (5) enthält, der das aus dem Referenz-Lichtwellenleiterstück (1; 10) austretende Licht in ein dessen Intensität entsprechendes elektrisches Signal umsetzt,
- und daß die Regelvorrichtung eine Regelschaltung (8) enthält, die aufgrund dieses elektrischen Signals die Wellenlänge des vom Halbleiterlaser (2) erzeugten Pumplichts so regelt, daß das in das Referenz-Lichtwellenleiterstück (1; 10) eingekoppelte Licht in diesem maximal absorbiert wird.

6. Faseroptischer Verstärker nach einem der Ansprüche 1 bis 5, dadurch gekennzeichnet, daß er Mittel (9) enthält, durch die die Temperatur seines Halbleiterlasers (2) steuerbar ist und daß die Regelvorrichtung die Wellenlänge des vom Halbleiterlaser (2) erzeugten Pumplichts über die Temperatur des Halbleiterlasers (2) regelt.

7. Faseroptischer Verstärker nach einem der Ansprüche 1 bis 5, dadurch gekennzeichnet, daß die Regelvorrichtung die Wellenlänge des vom Halbleiterlaser (2) erzeugten Pumplichts über den mittleren Betriebsstrom des Halbleiterlasers (2) regelt.

8. Faseroptischer Verstärker nach Anspruch 8 oder 9, dadurch gekennzeichnet, daß die Regelvorrichtung die Wellenlänge des vom Halbleiterlaser (2) erzeugten Pumplichts mit einer sehr niedrigen Frequenz moduliert und aus der mit dieser Frequenz stattfindenden Variation des Ausgangssignals des Photodetektors (5) ein solches Regelsignal ableitet, das die Wellenlänge des vom Halbleiterlaser (2) erzeugten Pumplichts so verschiebt, daß die Absorption des Pumplichts im Referenz-Lichtwellenleiterstück (1; 10) maximal wird.
